# EUROPEAN PATENT APPLICATION

(11) **EP 4 303 926 A1**
(43) Date of publication of application: **10.01.2024**
(21) Application number: 22209244.7
(22) Date of filing: 24.11.2022
(51) Int. Cl.: H01L 25/075, H01L 27/15, H01L 25/04, H01L 25/16, H01L 27/146

(54) **METHOD FOR MANUFACTURING POLYCHROME DEVICES AND POLYCHROME DISPLAY DEVICE**

(30) Priority: 06.07.2022 EP 22183211
(71) Applicant: Micledi Microdisplays BV, 3000 Leuven (BE)
(72) Inventor: Emmanuel, Le Boulbar, 1970 Wezembeek- Oppem (BE)
(74) Representative: Körfer, Thomas

(57) **Abstract**

A method (100) is provided for manufacturing a polychrome display or imaging device. The method comprises the steps of processing (101) a plurality of first semiconductor light emitting or detecting devices on a first semiconductor wafer, each configured to emit or detect light of a first color, processing (102) at least a plurality of second semiconductor light emitting or detecting devices on at least a second semiconductor wafer, each configured to emit or detect light of a second color, processing (103) an integrated circuit with driving devices for driving the plurality of first semiconductor light emitting or detecting devices and the plurality of second semiconductor light emitting or detecting devices on a third semiconductor wafer, and bonding (104) the first semiconductor wafer, at least the second semiconductor wafer, and the third semiconductor wafer in a stacked manner.

## Description

The invention relates to polychrome optical devices that operate on different wavelengths of light, particularly to polychrome displays or imagers or sensors comprising monochrome optical devices, especially for Augmented Reality (AR) applications.

In recent years, micro-display technology has been improved in terms of resolution, brightness, and energy consumption, especially to improve the performance of AR applications. One promising micro-display technology is a micro-display having one or more microscopic light emitting devices (e.g. microscopic light emitting diodes, micro-LEDs) on Complementary Metal-Oxide Semiconductor (CMOS).

For example, the document EP 3 667 721 A1 presents a monochrome device by integrating micro-LEDs (front-plane) with a CMOS readout (backplane). However, for polychrome devices, every different emission color requires a different epitaxial stack and further requires an effective backplane integration for driving the individual pixels, e.g. RGB pixels.

Another micro-display technology is a micro-display having separate monochrome dies, i.e. RGB dies, with combiner optics. In particular, three separate displays for three colors can be realized in independent lots and can be packaged in one module. The resulting output light can be optically combined by using optical waveguides, prism combiners, linear combiners, or a combination thereof.

However, this approach is cost-intensive and further increases the volume of the waveguide assembly.

Accordingly, an object of the invention is to provide a method for manufacturing polychrome devices and a polychrome display or imaging device, especially for facilitating a monolithic polychrome device in an integration flow that is compatible to existing CMOS foundries (CMOS fabs).

The object is solved by the features of the first independent claim for the method and by the features of the second independent claim for the polychrome display or imaging device. The dependent claims contain further developments.

According to a first aspect of the invention, a method is provided for manufacturing a polychrome display or imaging device. The method comprises the step of processing a plurality of first semiconductor light emitting or detecting devices on a first semiconductor wafer, each configured to emit or detect light of a first color. In addition, the method comprises the step of processing at least a plurality of second semiconductor light emitting or detecting devices on at least a second semiconductor wafer, each configured to emit or detect light of a second color.

Furthermore, the method comprises the step of processing an integrated circuit with driving devices for driving the plurality of first semiconductor light emitting or detecting devices and the plurality of second semiconductor light emitting or detecting devices on a third semiconductor wafer. Moreover, the method comprises the step of bonding the first semiconductor wafer, at least the second semiconductor wafer, and the third semiconductor wafer in a stacked manner.

Preferably, the first semiconductor wafer and the second semiconductor wafer should be understood as processed wafers. For instance, the first semiconductor wafer may be stacked on top of the third semiconductor wafer or CMOS wafer, and the second semiconductor wafer may be stacked on top of the first semiconductor wafer. In this regard, the substrate of the first semiconductor wafer may be removed or etched after stacking on top of the third semiconductor wafer or CMOS wafer, whereby leaving the film containing the plurality of first light emitting or detecting devices and/or any additional processes applied on the plurality of light emitting or detecting devices intact.

Similarly, the substrate of the second semiconductor wafer may be removed or etched after stacking on top of the first semiconductor wafer (already processed for the removal of the substrate of the first semiconductor wafer), whereby leaving the film containing the plurality of second light emitting or detecting devices and/or any additional processes applied on the plurality of second light emitting or detecting devices intact. In other words, the substrate of the first semiconductor wafer and the second semiconductor wafer may be respectively removed or etched after their respective bonding in the stack.

Therefore, the invention proposes a polychrome (e.g. RGB) pixel-by-pixel approach by realizing the separate colors in respective separate epitaxial layers, which are formed on a single CMOS backplane in a stacked manner. The individual light emitting or detecting devices of the respective separate epitaxial layers can be therefore individually addressed by the CMOS IC.

Furthermore, the polychrome pixels, especially the optical coupling and isolation of each polychrome pixel, can be separately optimized for the respective wavelength. Moreover, the stacked formation of different semiconductor wafers facilitates a separate common rail voltage for the respective light emitting or detecting devices on different semiconductor wafers.

Advantageously, a 3D stacked configuration for a polychrome display device can be realized that may comprise multiple semiconductor wafers having arrays of light emitting devices (e.g. LEDs). Each layer of the 3D stacked formation may operate on a different wavelength of light, e.g. red, green, or blue, and the light emitting devices may be driven or read out by the CMOS IC, e.g. individually or in a matrix formation.

Moreover, a 3D stacked configuration for an imaging device can be realized that may comprise multiple semiconductor wafers having arrays of light detecting devices, e.g. photo-gates, photo-transistors, or photodiodes. Each layer of the 3D stacked formation may operate on a different wavelength of light, e.g. near IR, UV, and so on, and the light detecting devices may be driven or read out by the CMOS IC, e.g. individually or in a matrix formation.

Preferably, the method comprises the step of bonding the first semiconductor wafer, at least the second semiconductor wafer, and the third semiconductor wafer according to a hybrid bonding technique. Additionally or alternatively, the method comprises the step of bonding the first semiconductor wafer, at least the second semiconductor wafer, and the third semiconductor wafer according to a dielectric bonding technique (e.g. fusion bonding).

Further alternatively, the bonding between the first semiconductor wafer, at least the second semiconductor wafer, and the third semiconductor wafer may comprise at least one dielectric bonding and at least one hybrid bonding.

Preferably, the method comprises the steps of processing a plurality of first contacts on the first semiconductor wafer corresponding to each of the plurality of first semiconductor light emitting or detecting devices. In addition, the method comprises the step of processing a plurality of second contacts on at least the second semiconductor wafer corresponding to each of the plurality of second semiconductor light emitting or detecting devices. Furthermore, the method comprises the step of processing a plurality of third contacts on the third semiconductor wafer connected to the integrated circuit, preferably a Complementary Metal-Oxide Semiconductor integrated circuit.

Moreover, the method comprises the step of bonding the first semiconductor wafer, at least the second semiconductor wafer, and the third semiconductor wafer in the stacked manner such that the plurality of first semiconductor light emitting or detecting devices are individually connected to the integrated circuit via the first contacts and the third contacts and at least the plurality of second semiconductor light emitting or detecting devices are individually connected to the integrated circuit via the second contacts and the third contacts. Advantageously, a monolithic polychrome display or imaging or sensor die can be realized, which can be driven by a single ASIC.

Preferably, the method comprises the step of processing electrical connections between the plurality of first semiconductor light emitting or detecting devices and the integrated circuit, preferably a Complementary Metal-Oxide Semiconductor integrated circuit, and/or between at least the plurality of second semiconductor light emitting or detecting devices and the integrated circuit with vias Advantageously, vertical interconnects between the stacked wafers can be effectively realized to achieve a compact 3D implementation of the polychrome display or imager, especially a 3D assembly with a small form-factor.

Preferably, the method comprises the step of processing the electrical connections between the plurality of first semiconductor light emitting or detecting devices and the integrated circuit, and between at least the plurality of second semiconductor light emitting or detecting devices and the integrated circuit simultaneously or sequentially. Advantageously, additional design flexibility and trade-offs have been incorporated, e.g. between a simultaneous via implementation with a multiple number of hard masks and a sequential via implementation with a reduced number of hard masks.

Preferably, the method comprises the step of processing a first plurality of optical structures on the first semiconductor wafer corresponding to each of the plurality of first semiconductor light emitting or detecting devices, and at least a second plurality of optical structures on at least the second semiconductor wafer corresponding to each of the plurality of second semiconductor light emitting or detecting devices.

Alternatively, the method comprises the step of processing a first plurality of optical structures corresponding to each of the plurality of first semiconductor light emitting or detecting devices and at least a second plurality of optical structures corresponding to each of the plurality of second semiconductor light emitting or detecting devices, especially after bonding the first semiconductor wafer, at least the second semiconductor wafer, and the third semiconductor wafer in the stacked manner.

In this regard, the first plurality of optical structures and the second plurality of optical structures comprise a digital lens, a digital lens system, a resonant cavity structure, a photo-scattering layer, or a combination thereof. Advantageously, the optical coupling of the individual light emitting or detecting devices on different semiconductor wafers can be effectively optimized for the respective wavelengths of the emitted or detected light, especially by incorporating wafer level optics.

Preferably, the method comprises the step of processing a first plurality of side-wall reflectors on the first semiconductor wafer corresponding to each of the plurality of first semiconductor light emitting or detecting devices, and at least a second plurality of side-wall reflectors on at least the second semiconductor wafer corresponding to each of the plurality of second semiconductor light emitting or detecting devices.

Advantageously, the optical and/or electrical isolation of the individual light emitting or detecting devices on different semiconductor wafers can be effectively optimized for the respective wavelengths of the emitted or detected light.

Preferably, the method further comprises the steps of dicing a first epitaxial wafer configured to emit or detect light of the first color and transferring onto the first semiconductor wafer in order to process the plurality of first light emitting or detecting devices on the first semiconductor wafer, and repeating the foregoing step for at least a second epitaxial wafer configured to emit or detect light of the second color in order to process at least the plurality of second light emitting or detecting devices on at least the second semiconductor wafer.

In this regard, the substrate size (e.g. 300mm) of the first semiconductor wafer and the second semiconductor wafer may correspond to the substrate size of the third semiconductor wafer (e.g. 300mm CMOS wafer). Further, the substrate size of the above-mentioned epitaxial wafers may differ (e.g. smaller) from the substrate size of the semiconductor and/or CMOS wafers. This advantageously facilitates an integration flow that is compatible with existing CMOS fabs, and therefore can be manufactured in high volumes.

Preferably, the method comprises the step of bonding the first semiconductor wafer, at least the second semiconductor wafer, and the third semiconductor wafer in the stacked manner so as to form individual pixel elements of the polychrome display or imaging device comprising at least one first semiconductor light emitting or detecting device and at least one second semiconductor light emitting or detecting device. In this regard, the at least one first semiconductor light emitting or detecting device and the at least one second light emitting or detecting device are arranged as a set of neighboring pixels in order to form the individual pixel elements of the polychrome display or imaging device.

Preferably, the method comprises the step of forming the individual pixel elements of the polychrome display or imaging device having a pixel pitch preferably less than 5 micrometers, more preferably having a pixel pitch of 3 micrometers. Advantageously, a high spatial resolution can be achieved.

According to a second aspect of the invention, a polychrome display or imaging device is provided. The polychrome display or imaging device comprises a first semiconductor wafer comprising a plurality of first semiconductor light emitting or detecting devices, each configured to emit or detect light of a first color, at least a second semiconductor wafer comprising at least a plurality of second semiconductor light emitting or detecting devices, each configured to emit or detect light of a second color, and a third semiconductor wafer comprising an integrated circuit with driving devices for driving the plurality of first semiconductor light emitting or detecting devices and the plurality of second semiconductor light emitting or detecting devices.

In this regard, the first semiconductor wafer, at least the second semiconductor wafer, and the third semiconductor wafer are bonded together in a stacked manner. Preferably, the first semiconductor wafer, at least the second semiconductor wafer, and the third semiconductor wafer are bonded together according to a hybrid bonding technique. Additionally or alternatively, the first semiconductor wafer, at least the second semiconductor wafer, and the third semiconductor wafer are bonded together according to a dielectric bonding technique. Further alternatively, the bonding between the first semiconductor wafer, at least the second semiconductor wafer, and the third semiconductor wafer may comprise at least one dielectric bonding and at least one hybrid bonding.

Preferably, the first semiconductor wafer and the second semiconductor wafer may be processed wafers, whereby the substrate of the first semiconductor wafer and the second semiconductor wafer may be respectively removed or etched after their respective bonding in the stack.

Preferably, the first semiconductor wafer comprises a first plurality of optical structures corresponding to each of the plurality of first semiconductor light emitting or detecting devices, and at least the second semiconductor wafer comprises at least a second plurality of optical structures corresponding to each of the plurality of second semiconductor light emitting or detecting devices.

Alternatively, the polychrome display or imaging device comprises a first plurality of optical structures corresponding to each of the plurality of first semiconductor light emitting or detecting devices and at least a second plurality of optical structures corresponding to each of the plurality of second semiconductor light emitting or detecting devices.

In this regard, the first plurality of optical structures and the second plurality of optical structures comprise a digital lens, a digital lens system, a resonant cavity structure, a photo-scattering layer, or a combination thereof.

Preferably, the first semiconductor wafer comprises a first plurality of side-wall reflectors corresponding to each of the plurality of first semiconductor light emitting or detecting devices, and at least the second semiconductor wafer comprises at least a second plurality of side-wall reflectors corresponding to each of the plurality of second semiconductor light emitting or detecting devices.

In this regard, the first plurality of side-wall reflectors and the second plurality of side-wall reflectors comprise a distributed Bragg reflector, a metallic mirror, an absorber layer, or a combination thereof.

Preferably, the first semiconductor wafer comprises a substrate wafer, especially a silicon wafer or a sapphire wafer or a germanium wafer or a GaAs wafer, having at least one compound semiconductor layer or is a compound semiconductor wafer.

In addition, the second semiconductor wafer comprises a substrate wafer, especially a silicon wafer or a sapphire wafer or a germanium wafer or a GaAs wafer, having at least one compound semiconductor layer or is a compound semiconductor wafer.

Preferably, the plurality of first semiconductor light emitting or detecting devices and at least the plurality of second semiconductor light emitting or detecting devices are compound semiconductor light emitting or detecting devices, preferably III-V compound semiconductor light emitting or detecting devices.

Alternatively, the plurality of first semiconductor light emitting or detecting devices are of a first group of compound, especially Gallium Nitride, GaN, semiconductor light emitting or detecting devices and at least the plurality of second semiconductor light emitting or detecting devices are of a second group of compound, especially Indium Gallium Arsenide, InGaAs, Aluminum Indium Gallium Phosphide, AlInGaP, semiconductor light emitting or detecting devices.

It is to be noted that the polychrome display or imaging device according to the second aspect corresponds to the method according to the first aspect and its implementation forms. Accordingly, the polychrome display or imaging device according to the second aspect achieves the same advantages and effects as the method of the first aspect and its respective implementation forms.

Exemplary embodiments of the invention are now further explained with respect to the drawings by way of example only, and not for limitation. In the drawings:
Fig. 1 shows an exemplary embodiment of the method according to the first aspect of the invention;
Figs. 2A-2B show an exemplary scheme to process light emitting devices on a semiconductor wafer;
Figs. 3A-3F show a first exemplary scheme to manufacture a polychrome display device;
Figs. 4A-4D show a second exemplary scheme to manufacture the polychrome display device;
Fig. 5 shows an exemplary RGB pixel arrangement of the polychrome display device;
Figs. 6A-6I show a third exemplary scheme to manufacture the polychrome display device; and
Figs. 7A-7C show a fourth exemplary scheme to manufacture the polychrome display device.

Reference will now be made in detail to the embodiments of the present invention, examples of which are illustrated in the accompanying drawings. However, the following embodiments of the present invention may be variously modified and the range of the present invention is not limited by the following embodiments. Reference signs for similar entities in different embodiments are partially omitted.

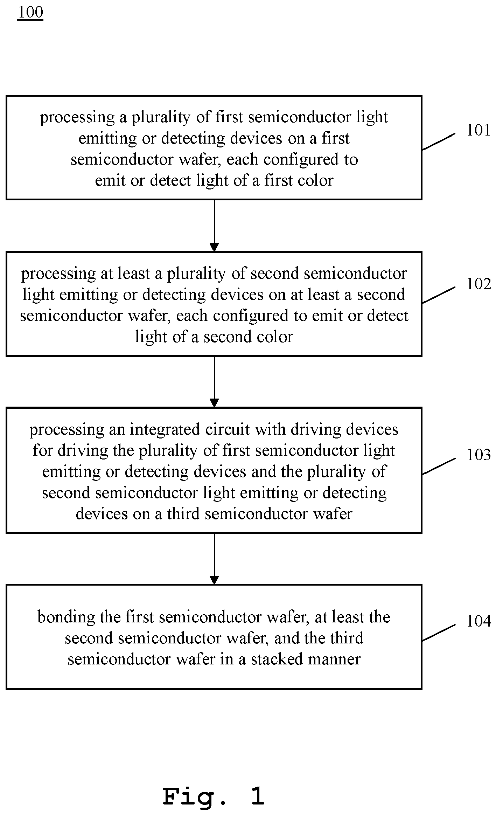

In Fig. 1, an exemplary embodiment of the method 100 according to the first aspect of the invention is illustrated. In a first step 101, a plurality of first semiconductor light emitting or detecting devices is processed on a first semiconductor wafer, each configured to emit or detect light of a first color. In a second step 102, at least a plurality of second semiconductor light emitting or detecting devices is processed on at least a second semiconductor wafer, each configured to emit or detect light of a second color.

In a third step 103, an integrated circuit is processed, especially with driving devices for driving the plurality of first semiconductor light emitting or detecting devices and the plurality of second semiconductor light emitting or detecting devices, on a third semiconductor wafer. In a fourth step 104, the first semiconductor wafer, at least the second semiconductor wafer, and the third semiconductor wafer are bonded together in a stacked manner.

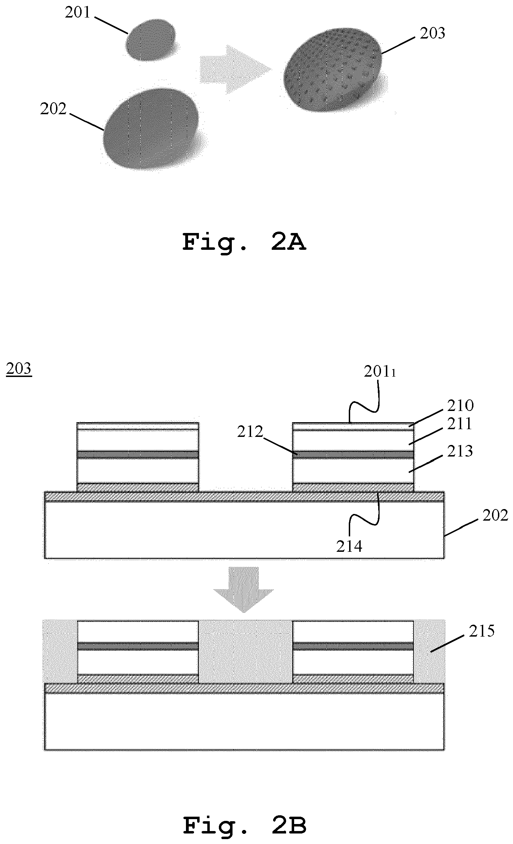

Along Figs. 2A-2B, an exemplary scheme to process light emitting devices 201₁ on a blank semiconductor wafer 202 is illustrated. Although Figs. 2A-2B exemplary show the processing of light emitting devices (e.g. LEDs), the underlying processing technique can be analogously implemented to process light detecting devices (e.g. PDs).

Particularly, Fig. 2A shows a process of resizing an epitaxial wafer 201, e.g. a GaN epi-wafer, from a smaller substrate size (e.g. 100-200 mm) to a target substrate size (e.g. 300 mm). In this regard, the epitaxial wafer 201 is diced to a die size corresponding to a target display size, for instance, a target emission area of 6 mm x 4 mm for Full High Definition (FHD). Afterwards, a blank silicon wafer 202 with the target substrate size (e.g. 300 mm) is re-populated with the diced epitaxial dies, thereby forming a semiconductor wafer 203 according to one or more aspects of this invention.

Fig. 2B shows the semiconductor wafer 203 in detail. Especially Fig. 2B shows two dies (e.g. the die 201₁) on the wafer 203, where the light emitting devices will be formed (not shown). As such, the transferred epitaxial dies 201₁ are further processed to form light emitting devices. Particularly, the gaps between the dies may be filled with filling materials 215 (e.g. SiO2, SiN), and the original epitaxial growth substrate 210 may be removed. Afterwards, light emitting mesa structures may be formed. Additionally, the ohmic contacts, for example, the cathode contacts, may be formed for the individual mesa structures.

The transferred epitaxial die 201₁ may comprise of a first high doped layer (e.g. n-doped layer) 211, an emission layer (e.g. MQW layer) 212, and a second high doped layer (e.g. p-doped layer) 213 in a stacked arrangement, where the stack is bonded via dielectric layers 214 to the blank semiconductor wafer 202, for example, at the p-doped layer 213 side. The light emitting mesa structures may be formed on the stacked arrangement of the epitaxial die 201₁. The mesa sidewalls may be covered by a sidewall reflector, e.g. a distributed Bragg reflector (DBR), which may serve the purpose of mesa sidewall passivation.

This process can be applied to three separate epitaxial wafers corresponding to three wavelengths of light, e.g. for emission of red, green, and blue light, thereby realizing different semiconductor wafers with the target substrate size having the respective red, green or blue light emitting mesa structures or light emitting devices or light emitting diodes.

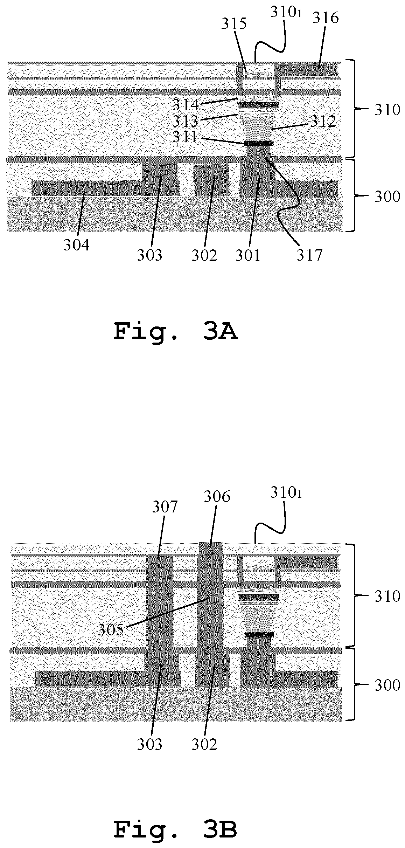

Along Figs. 3A-3F, a first exemplary scheme to manufacture a polychrome display device is illustrated. Although Figs. 3A-3F exemplary show the processing for the polychrome display device including the light emitting devices (e.g. LEDs), the underlying processing technique can be analogously implemented to process for an imaging or sensor device comprising light detecting devices (e.g. PDs).In particular, Fig. 3A shows a process of bonding a first semiconductor wafer 310 to a CMOS wafer 300.

The CMOS wafer may be for example a 300 mm CMOS wafer. The CMOS wafer 300 may be processed to comprise a CMOS IC 304 and a plurality of contacts electrically connected to the CMOS IC 304, exemplarily a first contact to CMOS IC 301, especially a plurality of first contact to CMOS IC 301, a second contact to CMOS IC 302, especially a plurality of second contact to CMOS IC 302, and a third contact to CMOS IC 303, especially a plurality of third contact to CMOS IC 303, e.g. via a Cu-damascene process or a dual-damascene process.

The first semiconductor wafer 310 may correspond to the semiconductor wafer 203, where additional post-processing may be performed, e.g. the removal of the blank wafer substrate 202 via Chemical-Mechanical Planarization (CMP) and/or grinding. The first semiconductor wafer 310 comprises a plurality of first light emitting devices, exemplarily a light emitting device or light emitting diode (LED) 310₁.

The LED 310₁ may comprise an n-doped layer 312 provided with the cathode contact or n-contact 311, a MQW layer 313, and a p-doped layer 314, and may be configured to emit light of blue color. The LED 310₁ may be further processed to comprise a lens or lens system 315 along with the anode contact or p-contact 316, preferably a common p-contact for the plurality of first light emitting devices. The p-contact 316 or the common p-contact may comprise or be a transparent ohmic contact.

The lens or lens system 315 may comprise or be a digital lens, a digital lens system, a resonant cavity structure, a photo-scattering layer, or a combination thereof. In this regard, the lens or lens system 315 may be optimized for the emission wavelength of the LED 310₁, e.g. emission of blue color.

The LED 310₁ may be further processed to comprise the bonding pad electrically coupled to the n-contact 311 in order to facilitate a metallic bonding. The processing of the bonding pad can be performed via a Cu-damascene process or a dual-damascene process. Afterwards, the first semiconductor wafer 310 may be hybrid bonded 317 to the CMOS wafer 300, i.e. a wafer-to-wafer bonding, especially by forming a dielectric bonding between the first semiconductor wafer 310 and the CMOS wafer 300 and by forming a metallic bonding between the bonding pad of the LED 310₁ (i.e. top bonding pad) and the first contact to CMOS IC 301 (i.e. bottom bonding pad).

Preferably, the additional processing of the first semiconductor wafer 310, e.g. the removal of the blank wafer substrate, lens processing, and p-contact processing, may be performed after the hybrid bonding of the first semiconductor wafer 310 to the CMOS wafer 300. Alternatively, the additional processing may be performed prior to the hybrid bonding.

In Fig. 3B, a process for realizing vias, especially through the first semiconductor wafer 310, is illustrated. For instance, a first via 305 may be formed in order to electrically extend the second contact to CMOS IC 302, and a second via 307 may be formed in order to electrically extend the third contact to CMOS IC 303, especially through the first semiconductor wafer 310.

In this example, the first via 305 and the second via 307 may be formed simultaneously. For instance, two hard masks (e.g. SiN or SiO2 based etch masks) can be used to etch a respective deep via to the second contact 302 and the third contact 303, respectively. Afterwards, the deep vias may be filled with copper, e.g. via a Cu-damascene process. At this stage, a further bonding pad 306 corresponding to the second contact 302 may be formed on the first via 305, e.g. via a Cu-damascene process, in order to facilitate metallic bonding.

Exemplarily, the first via 305 and the second via 307 may in the example have a width of 1-2 micrometers and a depth of 2 micrometers, and the further bonding pad 306 may in the example have a width of 1 micrometer and a depth of 500 nanometers.

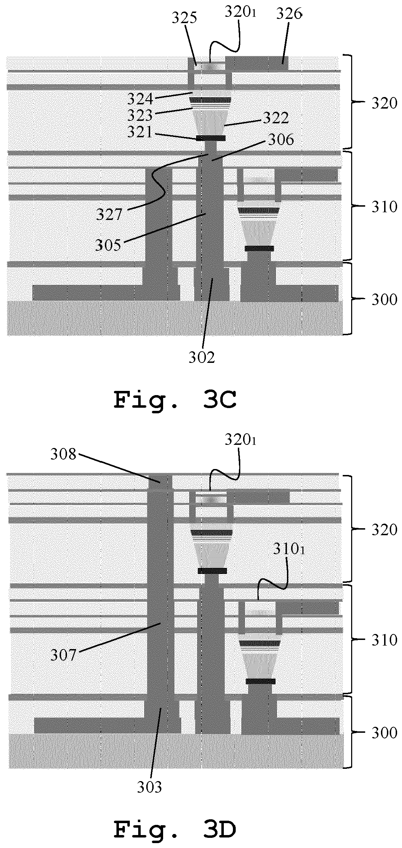

In Fig. 3C, a process of bonding a second semiconductor wafer 320 to the CMOS wafer 300, especially by stacking the second semiconductor wafer 320 on top of the first semiconductor wafer 310, is illustrated.

The second semiconductor wafer 320 may correspond to the semiconductor wafer 203, where additional post-processing may be performed, e.g. the removal of the blank wafer substrate 202 via CMP and/or grinding and/or etching. The second semiconductor wafer 320 comprises a plurality of second light emitting devices, exemplarily a light emitting device or LED 320₁.

The LED 320₁ may comprise an n-doped layer 322 provided with the cathode contact or n-contact 321, a MQW layer 323, and a p-doped layer 324, and may be configured to emit light of green color. The LED 320₁ may be further processed to comprise a lens or lens system 325 along with the anode contact or p-contact 326, preferably a common p-contact for the plurality of second light emitting devices. The p-contact 326 or the common p-contact may comprise or be a transparent ohmic contact.

The lens or lens system 325 may comprise or be a digital lens, a digital lens system, a resonant cavity structure, a photo-scattering layer, or a combination thereof. In this regard, the lens or lens system 325 may be optimized for the emission wavelength of the LED 320₁, e.g. emission of green color.

The LED 320₁ may be further processed to comprise the bonding pad electrically coupled to the n-contact 321 in order to facilitate a metallic bonding. The processing of the bonding pad can be performed via a Cu-damascene process or a dual-damascene process. Afterwards, the second semiconductor wafer 320 may be hybrid bonded 327 to the CMOS wafer 300, especially by forming a dielectric bonding between the second semiconductor wafer 320 and the first semiconductor wafer 310 and by forming a metallic bonding between the bonding pad of the LED 320₁ (i.e. top bonding pad) and the further bonding pad 306 (i.e. bottom bonding pad) corresponding to the second contact to CMOS IC 302.

Preferably, the additional processing of the second semiconductor wafer 320, e.g. the removal of the blank wafer substrate, lens processing, and p-contact processing, may be performed after the hybrid bonding of the second semiconductor wafer 320 to the CMOS wafer 300. Alternatively, the additional processing may be performed prior to the hybrid bonding.

In Fig. 3D, a process for extending a via, especially through the second semiconductor wafer 320, is illustrated. For instance, the second via 307 may be extended in order to electrically extend the third contact to CMOS IC 303, especially through the first semiconductor wafer 310 and further through the second semiconductor wafer 320.

For instance, a further hard mask (e.g. SiN or SiO2 based etch mask) can be used to etch a deep via towards the second via 307, especially to the second via 307 edge at the bonding interface 327. Afterwards, the deep via may be filled with copper, e.g. via a Cu-damascene process. At this stage, a further bonding pad 308 corresponding to the third contact 303 may be formed on the extended second via 307, e.g. via a Cu-damascene process, in order to facilitate metallic bonding.

Exemplarily, the extension of the second via 307 may for example have a width of 1-2 micrometers and a depth of 2 micrometers, and the further bonding pad 308 may for example have a width of 1 micrometer and a depth of 500 nanometers.

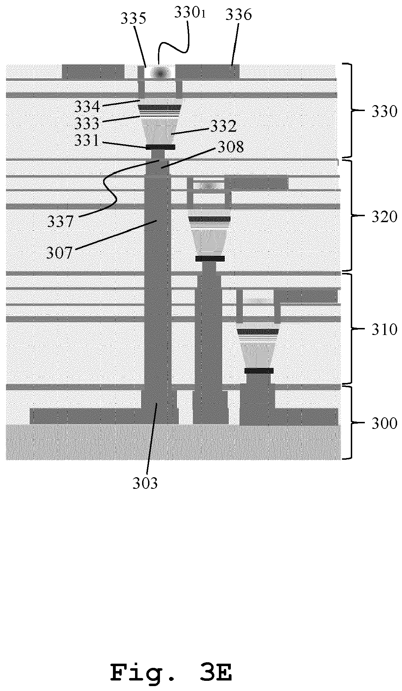

In Fig. 3E, a process of bonding a third semiconductor wafer 330 to the CMOS wafer 300, especially by stacking the third semiconductor wafer 330 on top of the second semiconductor wafer 320, is illustrated.

The third semiconductor wafer 330 may correspond to the semiconductor wafer 203, where additional post-processing may be performed, e.g. the removal of the blank wafer substrate 202 via CMP and/or grinding and/or etching. The third semiconductor wafer 330 comprises a plurality of third light emitting devices, exemplarily a light emitting device or LED 330₁.

The LED 330₁ may comprise an n-doped layer 332 provided with the cathode contact or n-contact 331, a MQW layer 333, and a p-doped layer 334, and may be configured to emit light of red color. The LED 330₁ may be further processed to comprise a lens or lens system 335 along with the anode contact or p-contact 336, preferably a common p-contact for the plurality of third light emitting devices. The p-contact 336 or the common p-contact may comprise or be a transparent ohmic contact.

The lens or lens system 335 may comprise or be a digital lens, a digital lens system, a resonant cavity structure, a photo-scattering layer, or a combination thereof. In this regard, the lens or lens system 335 may be optimized for the emission wavelength of the LED 330₁, e.g. emission of red color.

The LED 330₁ may be further processed to comprise the bonding pad electrically coupled to the n-contact 331 in order to facilitate a metallic bonding. The processing of the bonding pad can be performed via a Cu-damascene process or a dual-damascene process. Afterwards, the third semiconductor wafer 330 may be hybrid bonded 337 to the CMOS wafer 300, especially by forming a dielectric bonding between the third semiconductor wafer 330 and the second semiconductor wafer 320 and by forming a metallic bonding between the bonding pad of the LED 330₁ (i.e. top bonding pad) and the further bonding pad 308 (i.e. bottom bonding pad) corresponding to the third contact to CMOS IC 303.

Preferably, the additional processing of the third semiconductor wafer 330, e.g. the removal of the blank wafer substrate, lens processing, and p-contact processing, may be performed after the hybrid bonding of the third semiconductor wafer 330 to the CMOS wafer 300. Alternatively, the additional processing may be performed prior to the hybrid bonding.

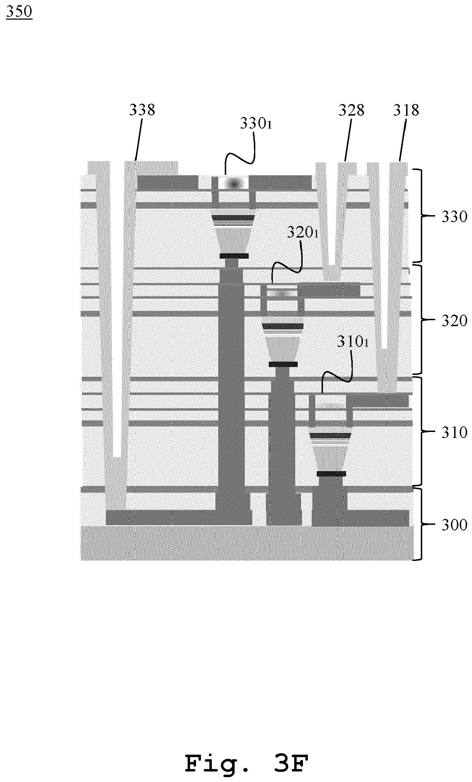

In Fig. 3F, a process to realize PASS/METPASS contacts, especially to facilitate electrical access to the LED 310₁, the LED 320₁, and the LED 330₁, is illustrated. A first PASS/METPASS contact 318 may be formed by using a first mask and by etching (e.g. dry etching) the dielectric layers of the third semiconductor wafer 330 and of the second semiconductor wafer 320, and by stopping the etching process at the first semiconductor wafer 310, especially at a probe pad electrically connected to the p-contact 316 of the first semiconductor wafer 310. Preferably, the etching may be configured to stop selectively at the probe pad of the first semiconductor wafer 310 (i.e. selectivity to copper).

Furthermore, a second PASS/METPASS contact 328 may be formed by using a second mask and by etching (e.g. dry etching) the dielectric layers of the third semiconductor wafer 330, and by stopping the etching process at the second semiconductor wafer 320, especially at a probe pad electrically connected to the p-contact 326 of the second semiconductor wafer 320. Preferably, the etching may be configured to stop selectively at the probe pad of the second semiconductor wafer 320 (i.e. selectivity to copper).

Moreover, a third PASS/METPASS contact 338 may be formed by using a third mask and by etching (e.g. dry etching) the dielectric layers of the third semiconductor wafer 330, of the second semiconductor wafer 320, and of the first semiconductor wafer 310, and by stopping the etching process at the CMOS wafer 300, especially at a probe pad electrically connected to the CMOS IC 304. Preferably, the etching may be configured to stop selectively at the probe pad of the CMOS wafer 300 (i.e. selectivity to copper).

As such, the PASS/METPASS contacts 318, 328, 338 may be formed by etching a respective large via through the stack, by filling the large via with metal (e.g. Aluminum), and by subsequent isolation via etching the metal. Due to the common contact nature of the p-contacts, one PASS/METPASS contact per layer may be sufficient to contact the LEDs (e.g. one contact 318 may be sufficient to contact all LEDs 310₁) . However, more than one PASS/METPASS contact per layer can be processed according to the above-mentioned technique.

The PASS/METPASS contacts 318, 328, 338 may have a dimension of about 40 µm × 60 µm. The first PASS/METPASS contact 318, the second PASS/METPASS contact 328, and the third PASS/METPASS contact 338 may be formed simultaneously, i.e. three simultaneous etching process. Alternatively, the first PASS/METPASS contact 318, the second PASS/METPASS contact 328, and the third PASS/METPASS contact 338 may be formed sequentially, i.e. there sequential etching process.

Therefore, a pixel level arrangement of a polychrome or RGB display device 350 is hereby illustrated. Exemplarily, The RGB display device 350 may comprise a first semiconductor wafer 310 comprising blue LEDs 310₁, a second semiconductor wafer 320 comprising green LEDs 320i, and a third semiconductor wafer 330 comprising red LEDs 330₁, especially stacked in a three-dimensional configuration (3D stacking) and are hybrid bonded to a CMOS wafer 300. Each of the blue LED 310₁, the green LED 320₁, and the red LED 330₁ is provided with a respective wafer-level optics, which are optimized for the respective emission wavelength.

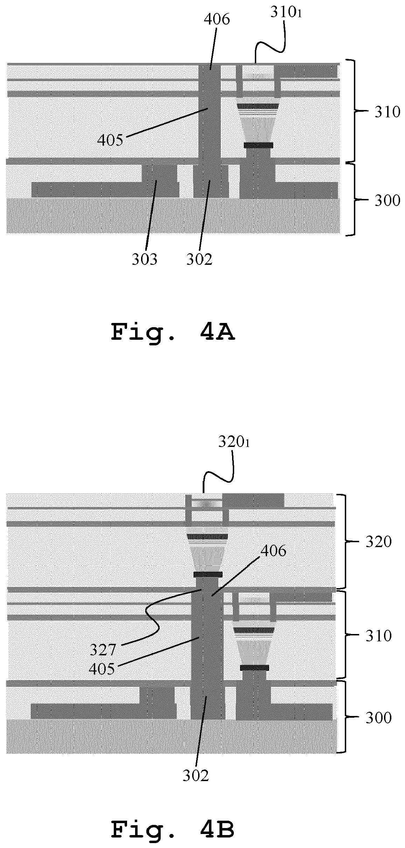

Along Figs. 4A-4D, a second exemplary scheme to manufacture the polychrome display device is illustrated. Although Figs. 4A-4D exemplary show the processing for the polychrome display device including the light emitting devices (e.g. LEDs), the underlying processing technique can be analogously implemented to process for an imaging or sensor device comprising light detecting devices (e.g. PDs).

The second exemplary scheme to manufacture the polychrome display device differs from the first exemplary scheme according to Figs. 3A-3F in that the vias are sequentially realized in order to reduce the number of hard masks. However, the manufacturing sequences as well as the structure of the polychrome display device remain the same.

In Fig. 4A, a process for realizing a first via, especially through the first semiconductor wafer 310, is illustrated. The process may be followed by the process illustrated along Fig. 3A and/or may be implemented as an alternative to the process illustrated along Fig. 3B. For instance, a first via 405 may be formed in order to electrically extend the second contact to CMOS IC 302, especially through the first semiconductor wafer 310.

For instance, a hard mask (e.g. SiN or SiO2 based etch mask) can be used to etch a deep via to the second contact 302. Afterwards, the deep via may be filled with copper, e.g. via a Cu-damascene process. At this stage, a further bonding pad 406 corresponding to the second contact 302 may be formed on the first via 405, e.g. via a Cu-damascene process, in order to facilitate metallic bonding.

Exemplarily, the first via 405 may for example have a width of 1-2 micrometers and a depth of 2 micrometers, and the further bonding pad 406 may have a width of 1 micrometer and a depth of 500 nanometers.

In Fig. 4B, a process of bonding the second semiconductor wafer 320 to the CMOS wafer 300, especially by stacking the second semiconductor wafer 320 on top of the first semiconductor wafer 310, is illustrated. The process may correspond to the process illustrated along Fig. 3C, and the processing of the second semiconductor wafer 320 may remain the same.

Accordingly, the second semiconductor wafer 320 may be hybrid bonded 327 to the CMOS wafer 300, especially by forming a dielectric bonding between the second semiconductor wafer 320 and the first semiconductor wafer 310 and by forming a metallic bonding between the bonding pad of the LED 320₁ (i.e. top bonding pad) and the further bonding pad 406 (i.e. bottom bonding pad) corresponding to the second contact to CMOS IC 302.

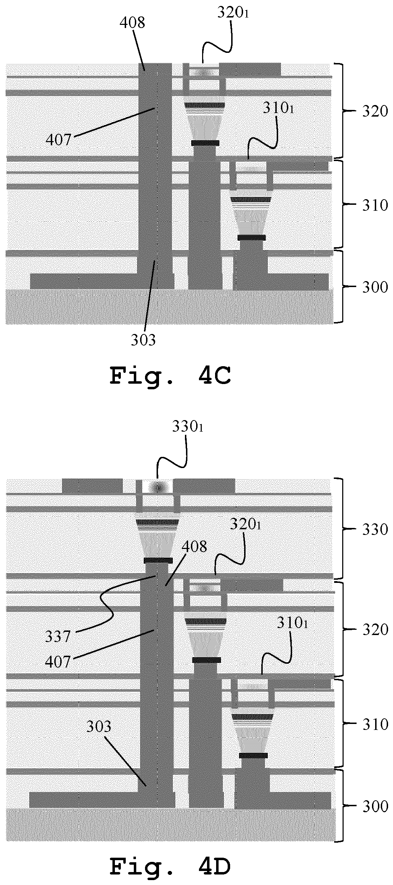

In Fig. 4C, a process for realizing a second via, especially through the second semiconductor wafer 320 and further through the first semiconductor wafer 310, is illustrated. The process may be followed by the process illustrated along Fig. 3C and/or may be implemented as an alternative to the process illustrated along Fig. 3D. For instance, a second via 407 may be formed in order to electrically extend the third contact to CMOS IC 303, especially through the first semiconductor wafer 310 and further through the second semiconductor wafer 320.

For instance, a hard mask (e.g. SiN or SiO2 based etch mask) can be used to etch a deep via to the third contact 303. Afterwards, the deep via may be filled with copper, e.g. via a Cu-damascene process. At this stage, a further bonding pad 408 corresponding to the third contact 303 may be formed on the second via 407, e.g. via a Cu-damascene process, in order to facilitate metallic bonding.

Exemplarily, the second via 407 may for example have a width of 1-2 micrometers and a depth of 4 micrometers, and the further bonding pad 408 may for example have a width of 1 micrometer and a depth of 500 nanometers.

In Fig. 4D, a process of bonding the third semiconductor wafer 330 to the CMOS wafer 300, especially by stacking the third semiconductor wafer 330 on top of the second semiconductor wafer 320, is illustrated. The process may correspond to the process illustrated along Fig. 3E, and the processing of the third semiconductor wafer 330 may remain the same.

Accordingly, the third semiconductor wafer 330 may be hybrid bonded 337 to the CMOS wafer 300, especially by forming a dielectric bonding between the third semiconductor wafer 330 and the second semiconductor wafer 320 and by forming a metallic bonding between the bonding pad of the LED 330₁ (i.e. top bonding pad) and the further bonding pad 408 (i.e. bottom bonding pad) corresponding to the third contact to CMOS IC 303.

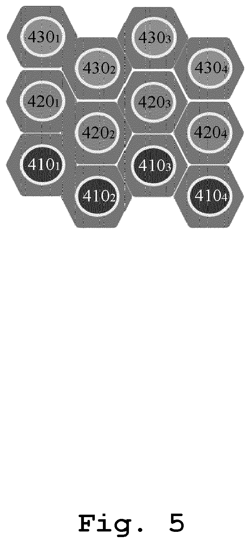

In Fig. 5, an exemplary RGB pixel arrangement of the polychrome display device 350 is illustrated. The arrangement exemplary shows four red LEDs 410₁-410₄, for example, realized on the first stacked semiconductor wafer, four green LEDs 420₁-420₄, for example, realized on the second stacked semiconductor wafer, and four blue LEDs 430₁-430₄, for example, realized on the third stacked semiconductor wafer, whereby hybrid bonding the semiconductor wafers to the CMOS wafer in order to drive the individual LEDs.

Herein, one or more LEDs may correspond to a sub-pixel of the display device 350 and an RGB pixel may comprise at least one red LED 410₁-410₄, at least one green LED 420₁-420₄, and at least one blue LED 430₁-430₄. Furthermore, the semiconductor wafers may be configured such that, when stacked on top of each other, a pixel pitch of less than 5 micrometers can be realized.

Moreover, the stacked semiconductor wafers may be configured such that, when stacked on top of each other, a top LED may not block the emission or obstruct the emission width or angle of a bottom LED, e.g. a green LED 420₁-420₄ on top of a blue LED 430₁-430₄, a red LED 410₁-410₄ on top of a green LED 420₁-420₄ and/or a blue LED 430₁-430₄ within the stacked arrangement. The above-mentioned exemplary RGB pixel arrangement can be analogously performed for an imaging or sensor device comprising pixelated light detecting devices (e.g. PDs), especially on different levels of the stacked arrangement.

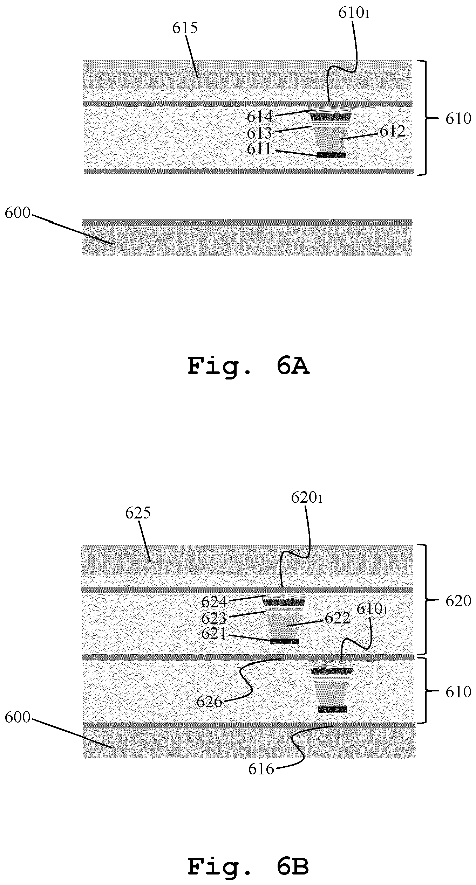

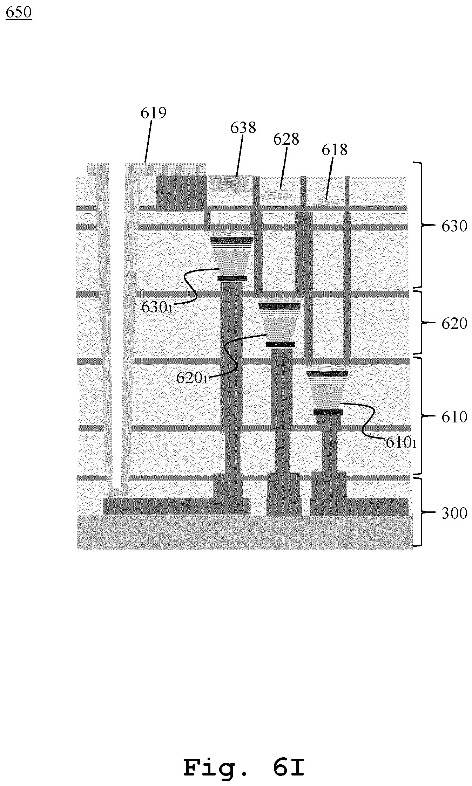

Along Figs. 6A-6I, a third exemplary scheme to manufacture a polychrome display device is illustrated. Although Figs. 6A-6I exemplary show the processing for the polychrome display device including the light emitting devices (e.g. LEDs), the underlying processing technique can be analogously implemented to process for an imaging or sensor device comprising light detecting devices (e.g. PDs). In particular, Fig. 6A shows a process of bonding a first semiconductor wafer 610 to a blank carrier wafer 600.

The carrier wafer may be a 300 mm silicon wafer. The first semiconductor wafer 610 may correspond to the semiconductor wafer 203, where additional post-processing may be performed, e.g. the removal of the growth substrate 210 via CMP and/or grinding and/or etching. The first semiconductor wafer 610 comprises a plurality of first light emitting devices, exemplarily a light emitting device or light emitting diode (LED) 610₁.

The LED 610₁ may comprise an n-doped layer 612 provided with the cathode contact or n-contact 611, a MQW layer 613, and a p-doped layer 614, and may be configured to emit light of blue color. The first semiconductor wafer 610 may comprise the substrate 615 corresponding to the blank silicon wafer 202.

In this regard, the first semiconductor wafer 610 may be flipped, and may be dielectrically bonded 616 (i.e. a wafer-to-wafer dielectric bonding) to the carrier wafer 600, i.e. the polished n-doped layer 611 side of the first semiconductor wafer 610 may be bonded to the carrier wafer 600 via dielectric layers. Afterwards, the substrate 615 corresponding to the blank silicon wafer 202 may be removed via CMP and/or grinding and/or etching.

Fig. 6B shows a process of bonding a second semiconductor wafer 620 to the first semiconductor wafer 610. The second semiconductor wafer 620 may correspond to the semiconductor wafer 203, where additional post-processing may be performed, e.g. the removal of the growth substrate 210 via CMP and/or grinding and/or etching. The second semiconductor wafer 620 comprises a plurality of second light emitting devices, exemplarily a light emitting device or light emitting diode (LED) 620₁.

The LED 620₁ may comprise an n-doped layer 622 provided with the cathode contact or n-contact 621, a MQW layer 623, and a p-doped layer 624, and may be configured to emit light of green color. The second semiconductor wafer 620 may comprise the substrate 625 corresponding to the blank silicon wafer 202.

In this regard, the second semiconductor wafer 620 may be flipped, and may be dielectrically bonded 626 (i.e. a wafer-to-wafer dielectric bonding) on top of the first semiconductor wafer 610, i.e. the polished n-doped layer 621 side of the second semiconductor wafer 620 may be bonded to the polished p-doped layer 614 side of the first semiconductor wafer 610 via dielectric layers. Afterwards, the substrate 625 corresponding to the blank silicon wafer 202 may be removed via CMP and/or grinding and/or etching.

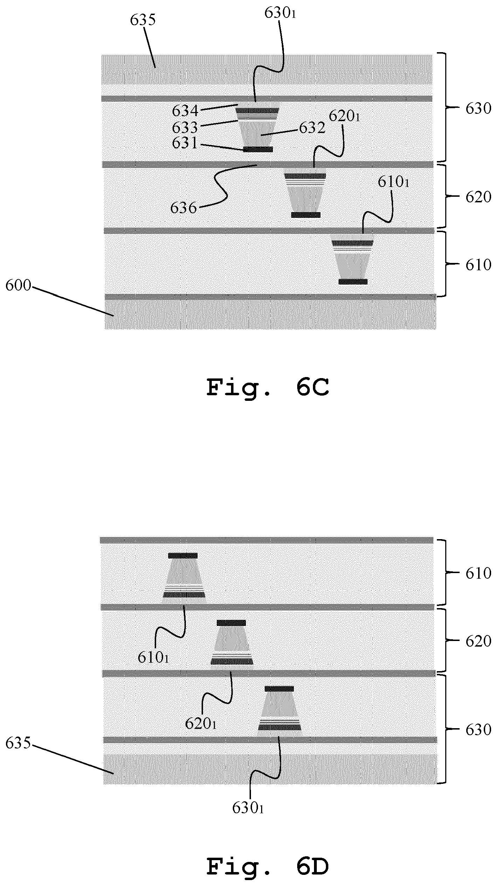

Fig. 6C shows a process of bonding a third semiconductor wafer 630 to the second semiconductor wafer 620. The third semiconductor wafer 630 may correspond to the semiconductor wafer 203, where additional post-processing may be performed, e.g. the removal of the growth substrate 210 via CMP and/or grinding and/or etching. The third semiconductor wafer 630 comprises a plurality of third light emitting devices, exemplarily a light emitting device or light emitting diode (LED) 630₁.

The LED 630₁ may comprise an n-doped layer 632 provided with the cathode contact or n-contact 631, a MQW layer 633, and a p-doped layer 634, and may be configured to emit light of red color. The third semiconductor wafer 630 may comprise the substrate 625 corresponding to the blank silicon wafer 202.

In this regard, the third semiconductor wafer 630 may be flipped, and may be dielectrically bonded 636 (i.e. a wafer-to-wafer dielectric bonding) on top of the second semiconductor wafer 620, i.e. the polished n-doped layer 631 side of the third semiconductor wafer 630 may be bonded to the polished p-doped layer 624 side of the second semiconductor wafer 620 via dielectric layers.

Fig. 6D shows a process of front-side removal of the stacked semiconductor wafers. In this regard, the stacked arrangement, especially the stacked arrangement of the carrier wafer 600, the first semiconductor wafer 601 on top of the carrier wafer 600, the second semiconductor wafer 602 on top of the first semiconductor wafer 601, and the third semiconductor wafer 603 on top of the second semiconductor wafer 602, may be flipped. Afterwards, the carrier wafer 600 substrate may be removed via CMP and/or grinding and/or etching.

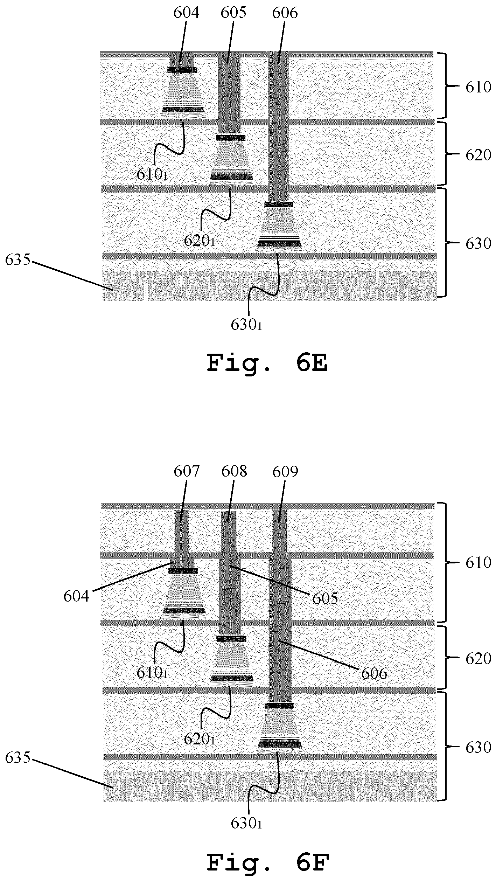

In Fig. 6E, a process for realizing vias, especially through the semiconductor wafers, is illustrated. For instance, the first via 604 may be formed by etching (e.g. dry etching) a first deep via to the n-contact 611 of the LED 610₁ according to a first hard mask (e.g. SiN or SiO2 based etch mask), and by filling the first deep via with copper, e.g. via a Cu-damascene process. The second via 605 may be formed by etching a second deep via to the n-contact 621 of the LED 620₁ according to a second hard mask, and by filling the second deep via with copper, e.g. via a Cu-damascene process.

Similarly, the third via 606 may be formed by etching a third deep via to the n-contact 631 of the LED 630₁ according to a third hard mask, and by filling the third deep via with copper, e.g. via a Cu-damascene process. In this regard, the first via 604, the second via 605, and the third via 606 may for example have a width of 1-2 micrometers and a depth of 500 nanometers, 2 micrometers, and 4 micrometers, respectively.

Alternatively, the first via 604, the second via 605, and the third via 606 may be realized by etching the first deep via, the second deep via, and the third deep via, respectively, according to a common hard mask, especially with a high etch stop selectivity to the n-contact material (e.g. a high selectivity to Titanium Nitride contacts).

In Fig. 6F, a process for realizing bonding pads, especially the bonding pads for the LEDs, is illustrated. For instance, a first bonding pad 607 may be formed on the first via 604, a second bonding pad 608 may be formed on the second via 605, and a third bonding pad 609 may be formed on the third via 606, especially to facilitate metallic bonding.

The first bonding pad 607, the second bonding pad 608, and the third bonding pad 609 may be formed according to a 500 nanometers Cu-damascene process, and the respective surface may be planarized or polished. As such, the first bonding pad 607, the second bonding pad 608, and the third bonding pad 609 may for example have a width of 1 micrometer and a depth of 500 nanometers.

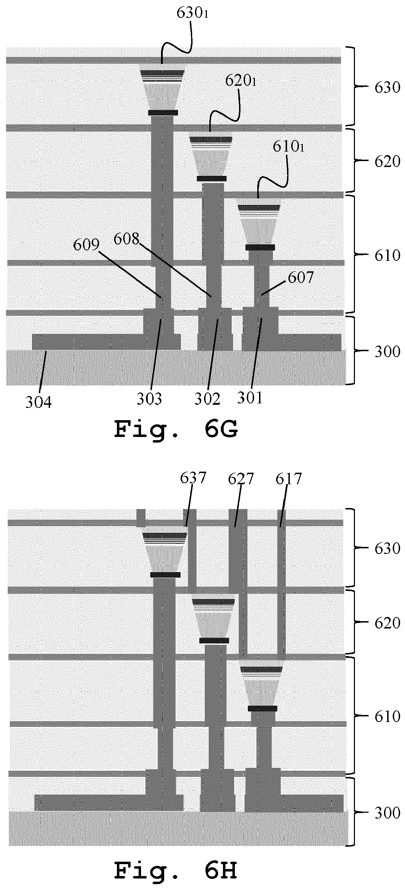

Fig. 6G shows a process of bonding the stacked semiconductor wafers, especially the first semiconductor wafer 610, the second semiconductor wafer 620, and the third semiconductor wafer 630, to the CMOS wafer 300. The stacked semiconductor wafers may be flipped, and may be hybrid bonded to the CMOS wafer 300. Particularly, the polished surface at the bonding pads of the stacked semiconductor wafers may be dielectrically bonded to the CMOS wafer 300 via dielectric materials.

Additionally, the first bonding pad 607 of the first semiconductor wafer 610, i.e. the bonding pad 607 of the LED 610₁, may be metallically bonded to the first contact 301 of the CMOS wafer 300. Furthermore, the second bonding pad 608 of the second semiconductor wafer 620, i.e. the bonding pad 608 of the LED 620₁, may be metallically bonded to the second contact 302 of the CMOS wafer 300.

Moreover, the third bonding pad 609 of the third semiconductor wafer 630, i.e. the bonding pad 609 of the LED 630₁, may be metallically bonded to the third contact 303 of the CMOS wafer 300. Afterwards, the substrate 635 corresponding to the blank silicon wafer 202 may be removed from the third semiconductor wafer 630 via CMP and/or grinding and/or etching.

Fig. 6H shows a process of realizing anodes or p-contacts, especially for the LEDs. In this regard, a first anode or p-contact 617 may be formed on the first semiconductor wafer 610, especially to electrically couple the p-doped layer 614 of the LED 610₁, for instance, via a Cu-damascene or a dual-damascene process through the third semiconductor wafer 630 and further through the second semiconductor wafer 620.

Furthermore, a second anode or p-contact 627 may be formed on the second semiconductor wafer 620, especially to electrically couple the p-doped layer 624 of the LED 620₁, for instance, via a Cu-damascene or a dual-damascene process through the third semiconductor wafer 630. Moreover, a third anode or p-contact 637 may be formed on the third semiconductor wafer 630, especially to electrically couple the p-doped layer 634 of the LED 630₁, for instance, via a Cu-damascene or a dual-damascene process.

In this regard, the first anode 617 may be a common anode for all blue LEDs 610₁, the second anode 627 may be a common anode for all green LEDs 620₁, and the third anode 637 may be a common anode for all red LEDs 630₁.

Fig. 61 shows a process of realizing lenses, especially wafer level lenses, for the LEDs. In this regard, the LED 610₁ may be further processed to comprise a first lens or lens system 618, preferably optimized for the emission wavelength of the LED 610₁, e.g. emission of blue color.

Furthermore, the LED 620₁ may be further processed to comprise a second lens or lens system 628, preferably optimized for the emission wavelength of the LED 620₁, e.g. emission of green color. Moreover, the LED 630₁ may be further processed to comprise a third lens or lens system 638, preferably optimized for the emission wavelength of the LED 630₁, e.g. emission of red color.

The first lens or lens system 618, the second lens or lens system 628, and the third lens or lens system 638 may comprise or be a digital lens, a digital lens system, a resonant cavity structure, a photo-scattering layer, or a combination thereof.

In addition, a process to realize a PASS/METPASS contact is also shown, especially to facilitate electrical access to the CMOS IC 304. A PASS/METPASS contact 619 may be formed by using a mask and by etching (e.g. dry etching) the dielectric layers of the third semiconductor wafer 630, of the second semiconductor wafer 620, and of the first semiconductor wafer 610, and by stopping the etching process at the CMOS wafer 300, especially at a probe pad electrically connected to the CMOS IC 304.

For instance, the PASS/METPASS contact 619 may be formed by etching a large via through the stack, by filling the large via with metal (e.g. Aluminum), and by subsequent isolation via etching the metal. Preferably, the etching may be configured to stop selectively at the probe pad of the CMOS wafer 300 (i.e. selectivity to copper). The PASS/METPASS contact 619 may for example have a dimension of about 40 µm x 60 µm.

Therefore, a pixel level arrangement of a polychrome or RGB display device 650 is hereby illustrated. Exemplarily, The RGB display device 650 may comprise a first semiconductor wafer 610 comprising blue LEDs 610₁, a second semiconductor wafer 620 comprising green LEDs 620i, and a third semiconductor wafer 630 comprising red LEDs 630₁, especially stacked in a three-dimensional configuration (3D stacking) and are hybrid bonded to a CMOS wafer 300. Each of the blue LED 610₁, the green LED 620₁, and the red LED 630₁ is provided with a respective wafer-level optics 618, 628, 638, which is optimized for the respective emission wavelength.

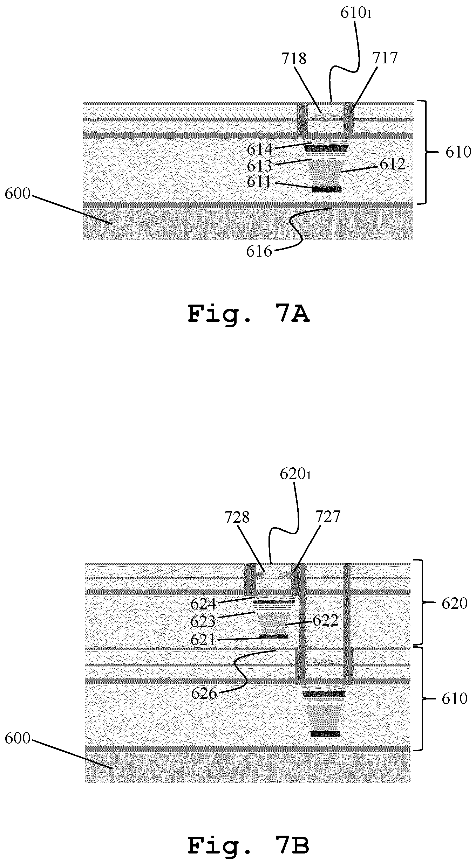

Along Figs. 7A-7C, a fourth exemplary scheme to manufacture a polychrome display device is illustrated. Although Figs. 7A-7C exemplary show the processing for the polychrome display device including the light emitting devices (e.g. LEDs), the underlying processing technique can be analogously implemented to process for an imaging or sensor device comprising light detecting devices (e.g. PDs).

The fourth exemplary scheme to manufacture the polychrome display device differs from the third exemplary scheme according to Figs. 6A-6I in that the lens or lens systems of the LEDs have been processed during the processing of the respective semiconductor wafers. However, the manufacturing sequences according to the third exemplary embodiment may remain the same.

Fig. 7A shows a process to realize a first lens or lens system 718 on the first semiconductor wafer 610. The process can be implemented as an additional step to the process illustrated along Fig. 6A above. In this regard, after removing the substrate 615 of the first semiconductor wafer 610 corresponding to the blank silicon wafer 202 via CMP and/or grinding and/or etching, a first anode or p-contact 717 may be formed on the first semiconductor wafer 610, especially to electrically couple the p-doped layer 614 of the LED 610₁, for instance, via a Cu-damascene or a dual-damascene process.

In addition, the LED 610₁ may be further processed to comprise a first lens or lens system 718, preferably optimized for the emission wavelength of the LED 610₁, e.g. emission of blue color. In this regard, the first lens or lens system 718 may comprise or be a digital lens, a digital lens system, a resonant cavity structure, a photo-scattering layer, or a combination thereof.

Fig. 7B shows a process to realize a second lens or lens system 728 on the second semiconductor wafer 620. The process can be implemented as an additional step to the process illustrated along Fig. 6B above. In this regard, after removing the substrate 625 of the second semiconductor wafer 620 corresponding to the blank silicon wafer 202 via CMP and/or grinding and/or etching, a second anode or p-contact 727 may be formed on the second semiconductor wafer 610, as well as the first anode or p-contact 717 may be extended, especially to electrically couple the p-doped layer 624 of the LED 620₁, and the p-doped layer 614 of the LED 610₁, respectively, for instance, via a Cu-damascene or a dual-damascene process.

In addition, the LED 620₁ may be further processed to comprise a second lens or lens system 728, preferably optimized for the emission wavelength of the LED 620₁, e.g. emission of green color. In this regard, the second lens or lens system 728 may comprise or be a digital lens, a digital lens system, a resonant cavity structure, a photo-scattering layer, or a combination thereof.

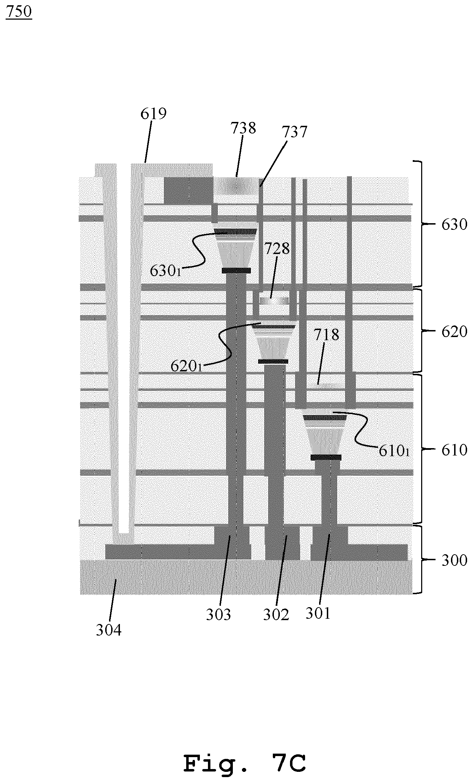

Fig. 7C shows a process to realize a third lens or lens system 738 on the third semiconductor wafer 630. The process can be implemented as an additional step to the process illustrated along Fig. 6G above. In this regard, after removing the substrate 635 of the third semiconductor wafer 630 corresponding to the blank silicon wafer 202 via CMP and/or grinding and/or etching, a third anode or p-contact 737 may be formed on the third semiconductor wafer 630, as well as the second anode or p-contact 727 and the first anode or p-contact 717 may be extended, especially to electrically couple the p-doped layer 634 of the LED 6301, the p-doped layer 624 of the LED 620₁, and the p-doped layer 614 of the LED 610₁, respectively, for instance, via a Cu-damascene or a dual-damascene process.

In addition, the LED 630₁ may be further processed to comprise a third lens or lens system 738, preferably optimized for the emission wavelength of the LED 630₁, e.g. emission of red color. In this regard, the third lens or lens system 738 may comprise or be a digital lens, a digital lens system, a resonant cavity structure, a photo-scattering layer, or a combination thereof.

In this regard, the extended first anode or p-contact 717 may comprise or be a spacer for optical out-coupling of emission of the LED 610₁, the extended second anode or p-contact 727 may comprise or be a spacer for optical out-coupling of emission of the LED 620₁, and the third anode or p-contact 737 may comprise or be a spacer for optical out-coupling of emission of the LED 630₁.

Therefore, a pixel level arrangement of a polychrome or RGB display device 750 is hereby illustrated. Exemplarily, the RGB display device 750 may comprise a first semiconductor wafer 610 comprising blue LEDs 610₁, a second semiconductor wafer 620 comprising green LEDs 620i, and a third semiconductor wafer 630 comprising red LEDs 630₁, especially stacked in a three-dimensional configuration (3D stacking) and are hybrid bonded to a CMOS wafer 300.

Each of the blue LED 610₁, the green LED 620₁, and the red LED 630₁ is provided with a respective wafer-level optics 718, 728, 738, which is optimized for the respective emission wavelength, especially realized at different depths corresponding to the first semiconductor wafer 610, the second semiconductor wafer 620, and the third semiconductor wafer 630, respectively.

It is important to note that, the word "coupled" implies that the elements may be directly connected together or may be coupled through one or more intervening elements. Furthermore, in the description as well as in the claims, the word "comprising" does not exclude other elements or steps and the indefinite article "a" or "an" does not exclude a plurality. A single element or other unit may fulfill the functions of several entities or items recited in the claims. Moreover, the description with regard to any of the aspects is also relevant with regard to the other aspects of the invention.

Although the invention has been illustrated and described with respect to one or more implementations, equivalent alterations and modifications will occur to others skilled in the art upon the reading and understanding of this specification and the annexed drawings. In addition, while a particular feature of the invention may have been disclosed with respect to only one of several implementations, such feature may be combined with one or more other features of the other implementations as may be desired and advantageous for any given or particular application.

## Claims

1. A method (100) for manufacturing a polychrome display or imaging device comprising the steps of:
processing (101) a plurality of first semiconductor light emitting or detecting devices (310₁, 610₁) on a first semiconductor wafer (310, 610), each configured to emit or detect light of a first color,
processing (102) at least a plurality of second semiconductor light emitting or detecting devices (320₁, 620₁) on at least a second semiconductor wafer (320, 620), each configured to emit or detect light of a second color,
processing (103) an integrated circuit (304) with driving devices for driving the plurality of first semiconductor light emitting or detecting devices (310₁, 610₁) and the plurality of second semiconductor light emitting or detecting devices (320₁, 620₁) on a third semiconductor wafer (300), and
bonding (104) the first semiconductor wafer (310, 610), at least the second semiconductor wafer (320, 620), and the third semiconductor wafer (300) in a stacked manner.

2. The method according to claim 1,
wherein the method further comprises the step of bonding the first semiconductor wafer (310, 610), at least the second semiconductor wafer (320, 620), and the third semiconductor wafer (300) according to a hybrid bonding technique and/or a dielectric bonding technique.

3. The method according to claim 1 or 2,
wherein the method further comprises the steps of:
processing a plurality of first contacts (311, 611) on the first semiconductor wafer (310, 610) corresponding to each of the plurality of first semiconductor light emitting or detecting devices (310₁, 610₁),
processing a plurality of second contacts (321, 621) on at least the second semiconductor wafer (320, 620) corresponding to each of the plurality of second semiconductor light emitting or detecting devices (320₁, 620₁),
processing a plurality of third contacts (301, 302, 303) on the third semiconductor wafer (300) connected to the integrated circuit (304), preferably a Complementary Metal-Oxide Semiconductor integrated circuit, and
bonding the first semiconductor wafer (310, 610), at least the second semiconductor wafer (320, 620), and the third semiconductor wafer (300) in the stacked manner such that the plurality of first semiconductor light emitting or detecting devices (310₁, 610₁) are individually connected to the integrated circuit (304) via the first contacts (311, 611) and the third contacts (301) and at least the plurality of second semiconductor light emitting or detecting devices (320₁, 620₁) are individually connected to the integrated circuit (304) via the second contacts (321, 621) and the third contacts (302).

4. The method according to any of claims 1 to 3,
wherein the method further comprises the step of processing electrical connections between the plurality of first semiconductor light emitting or detecting devices (310₁, 610₁) and the integrated circuit (304), preferably a Complementary Metal-Oxide Semiconductor integrated circuit (304), and/or between at least the plurality of second semiconductor light emitting or detecting devices (320₁, 620₁) and the integrated circuit (304) with vias (305, 405, 604, 605) .

5. The method according to claim 4,
wherein the method further comprises the step of processing the electrical connections between the plurality of first semiconductor light emitting or detecting devices (310₁, 610₁) and the integrated circuit (304), and between at least the plurality of second semiconductor light emitting or detecting devices (320₁, 620₁) and the integrated circuit (304) simultaneously or sequentially.

6. The method according to any of claims 1 to 5,
wherein the method further comprises the step of processing a first plurality of optical structures (315, 718) on the first semiconductor wafer (310, 610) corresponding to each of the plurality of first semiconductor light emitting or detecting devices (310₁, 610₁), and at least a second plurality of optical structures (325, 728) on at least the second semiconductor wafer (320, 620) corresponding to each of the plurality of second semiconductor light emitting or detecting devices (320₁, 620₁), or
wherein the method further comprises the step of processing a first plurality of optical structures (618) corresponding to each of the plurality of first semiconductor light emitting or detecting devices (310₁, 610₁) and at least a second plurality of optical structures (628) corresponding to each of the plurality of second semiconductor light emitting or detecting devices (320₁, 620₁), especially after bonding the first semiconductor wafer (310, 610), at least the second semiconductor wafer (320, 620), and the third semiconductor wafer (300) in the stacked manner.

7. The method according to claim 6,
wherein the first plurality of optical structures (315, 618, 718) and the second plurality of optical structures (325, 628, 728) comprise a digital lens, a digital lens system, a resonant cavity structure, a photo-scattering layer, or a combination thereof.

8. The method according to any of claims 1 to 7,
wherein the method further comprises the step of processing a first plurality of side-wall reflectors on the first semiconductor wafer (310, 610) corresponding to each of the plurality of first semiconductor light emitting or detecting devices (310₁, 610₁), and at least a second plurality of side-wall reflectors on at least the second semiconductor wafer (320, 620) corresponding to each of the plurality of second semiconductor light emitting or detecting devices (320₁, 620₁).

9. The method according to any of claims 1 to 8,
wherein the method further comprises the steps of:
a) dicing a first epitaxial wafer configured to emit or detect light of the first color and transferring onto the first semiconductor wafer (310, 610) in order to process the plurality of first light emitting or detecting devices (310₁, 610₁) on the first semiconductor wafer (310, 610), and
b) repeating step a) for at least a second epitaxial wafer configured to emit or detect light of the second color in order to process at least the plurality of second light emitting or detecting devices (320₁, 620₁) on at least the second semiconductor wafer (320, 620).

10. The method according to any of claims 1 to 9,
wherein the method further comprises the step of bonding the first semiconductor wafer (310, 610), at least the second semiconductor wafer (320, 620), and the third semiconductor wafer (300) in the stacked manner so as to form individual pixel elements of the polychrome display or imaging device comprising at least one first semiconductor light emitting or detecting device (310₁, 610₁) and at least one second semiconductor light emitting or detecting device (320₁, 620₁), and
wherein the at least one first semiconductor light emitting or detecting device (310₁, 610₁) and the at least one second light emitting or detecting device (320₁, 620₁) are arranged as a set of neighboring pixels in order to form the individual pixel elements of the polychrome display or imaging device.

11. The method according to claim 10,
wherein the method further comprises the step of forming the individual pixel elements of the polychrome display or imaging device having a pixel pitch preferably less than 5 micrometers.

12. A polychrome display or imaging device (350, 650, 750) comprising:
a first semiconductor wafer (310, 610) comprising a plurality of first semiconductor light emitting or detecting devices (310₁, 610₁), each configured to emit or detect light of a first color,
at least a second semiconductor wafer (320, 620) comprising at least a plurality of second semiconductor light emitting or detecting devices (320₁, 620₁), each configured to emit or detect light of a second color, and
a third semiconductor wafer (300) comprising an integrated circuit (304) with driving devices for driving the plurality of first semiconductor light emitting or detecting devices (310₁, 610₁) and the plurality of second semiconductor light emitting or detecting devices (320₁, 620₁),
wherein the first semiconductor wafer (310, 610), at least the second semiconductor wafer (320, 620), and the third semiconductor wafer (300) are bonded together in a stacked manner.

13. The polychrome display or imaging device according to claim 12,
wherein the first semiconductor wafer (310, 610) comprises a first plurality of optical structures (315, 718) corresponding to each of the plurality of first semiconductor light emitting or detecting devices (310₁, 610₁), and at least the second semiconductor wafer (320, 620) comprises at least a second plurality of optical structures (325, 728) corresponding to each of the plurality of second semiconductor light emitting or detecting devices (320₁, 620₁), or
wherein the polychrome display or imaging device comprises a first plurality of optical structures (618) corresponding to each of the plurality of first semiconductor light emitting or detecting devices (310₁, 610₁) and at least a second plurality of optical structures (628) corresponding to each of the plurality of second semiconductor light emitting or detecting devices (320₁, 620₁),and
wherein the first plurality of optical structures (315, 618, 718) and the second plurality of optical structures (325, 628, 728) comprise a digital lens, a digital lens system, a resonant cavity structure, a photo-scattering layer, or a combination thereof.

14. The polychrome display or imaging device according to claim 12 or 13,
wherein the first semiconductor wafer (310, 610) comprises a first plurality of side-wall reflectors corresponding to each of the plurality of first semiconductor light emitting or detecting devices (310₁, 610₁), and at least the second semiconductor wafer (320, 620) comprises at least a second plurality of side-wall reflectors corresponding to each of the plurality of second semiconductor light emitting or detecting devices (320₁, 620₁), and
wherein the first plurality of side-wall reflectors and the second plurality of side-wall reflectors comprise a distributed Bragg reflector, a metallic mirror, an absorber layer, or a combination thereof.

15. The polychrome display or imaging device according to any of claims 12 to 14,
wherein the first semiconductor wafer (310, 610) comprises a substrate wafer, especially a silicon wafer or a sapphire wafer or a germanium wafer or a GaAs wafer, having at least one compound semiconductor layer or is a compound semiconductor wafer, and
wherein the second semiconductor wafer (320, 620) comprises a substrate wafer, especially a silicon wafer or a sapphire wafer or a germanium wafer or a GaAs wafer, having at least one compound semiconductor layer or is a compound semiconductor wafer.

16. The polychrome display or imaging device according to any of claims 12 to 15,
wherein the plurality of first semiconductor light emitting or detecting devices (310₁, 610₁) and at least the plurality of second semiconductor light emitting or detecting devices (320₁, 620₁) are compound semiconductor light emitting or detecting devices, preferably III-V compound semiconductor light emitting or detecting devices, or
wherein the plurality of first semiconductor light emitting or detecting devices (310₁, 610₁) are of a first group of compound, especially Gallium Nitride, GaN, semiconductor light emitting or detecting devices and at least the plurality of second semiconductor light emitting or detecting devices (320₁, 620₁) are of a second group of compound, especially Indium Gallium Arsenide, InGaAs, Aluminum Indium Gallium Phosphide, AlInGaP, semiconductor light emitting or detecting devices.

## Amended claims

### Amended claims in accordance with Rule 137(2) EPC.

1. A method (100) for manufacturing a polychrome display or imaging device comprising the steps of:
processing (101) a plurality of first semiconductor light emitting or detecting devices (610₁) on a first semiconductor wafer (203), each configured to emit or detect light of a first color, to realize a first processed semiconductor wafer (610),
processing (102) at least a plurality of second semiconductor light emitting or detecting devices (620₁) on at least a second semiconductor wafer (203), each configured to emit or detect light of a second color, to realize a second processed semiconductor wafer (620),
processing (103) an integrated circuit (304) with driving devices for driving the plurality of first semiconductor light emitting or detecting devices (610₁) and the plurality of second semiconductor light emitting or detecting devices (620₁) on a third semiconductor wafer (300), and
bonding (104) the first processed semiconductor wafer (610), at least the second processed semiconductor wafer (620), and the third semiconductor wafer (300) in a stacked manner,
wherein the bonding between the first processed semiconductor wafer (610), at least the second processed semiconductor wafer (620), and the third semiconductor wafer (300) comprises at least one dielectric bonding and at least one hybrid bonding.

2. The method according to claim 1,
wherein the method further comprises the steps of:
processing a plurality of first contacts (611) on the first processed semiconductor wafer (610) corresponding to each of the plurality of first semiconductor light emitting or detecting devices (610₁),
processing a plurality of second contacts (621) on at least the second processed semiconductor wafer (620) corresponding to each of the plurality of second semiconductor light emitting or detecting devices (620₁),
processing a plurality of third contacts (301, 302, 303) on the third semiconductor wafer (300) connected to the integrated circuit (304), preferably a Complementary Metal-Oxide Semiconductor integrated circuit, and
bonding the first processed semiconductor wafer (610), at least the second processed semiconductor wafer (620), and the third semiconductor wafer (300) in the stacked manner such that the plurality of first semiconductor light emitting or detecting devices (610₁) are individually connected to the integrated circuit (304) via the first contacts (611) and the third contacts (301) and at least the plurality of second semiconductor light emitting or detecting devices (620₁) are individually connected to the integrated circuit (304) via the second contacts (621) and the third contacts (302).

3. The method according to of claim 1 or 2,
wherein the method further comprises the step of processing electrical connections between the plurality of first semiconductor light emitting or detecting devices (610₁) and the integrated circuit (304), preferably a Complementary Metal-Oxide Semiconductor integrated circuit (304), and/or between at least the plurality of second semiconductor light emitting or detecting devices (620₁) and the integrated circuit (304) with vias (604, 605).

4. The method according to claim 3,
wherein the method further comprises the step of processing the electrical connections between the plurality of first semiconductor light emitting or detecting devices (610₁) and the integrated circuit (304), and between at least the plurality of second semiconductor light emitting or detecting devices (620₁) and the integrated circuit (304) simultaneously or sequentially.

5. The method according to any of claims 1 to 4,
wherein the method further comprises the step of processing a first plurality of optical structures (718) on the first processed semiconductor wafer (610) corresponding to each of the plurality of first semiconductor light emitting or detecting devices (610₁), and at least a second plurality of optical structures (728) on at least the second processed semiconductor wafer (620) corresponding to each of the plurality of second semiconductor light emitting or detecting devices (620₁), or
wherein the method further comprises the step of processing a first plurality of optical structures (618) corresponding to each of the plurality of first semiconductor light emitting or detecting devices (610₁) and at least a second plurality of optical structures (628) corresponding to each of the plurality of second semiconductor light emitting or detecting devices (620₁), especially after bonding the first processed semiconductor wafer (610), at least the second processed semiconductor wafer (620), and the third semiconductor wafer (300) in the stacked manner.

6. The method according to claim 5,
wherein the first plurality of optical structures (618, 718) and the second plurality of optical structures (628, 728) comprise a digital lens, a digital lens system, a resonant cavity structure, a photo-scattering layer, or a combination thereof.

7. The method according to any of claims 1 to 6,
wherein the method further comprises the step of processing a first plurality of side-wall reflectors on the first processed semiconductor wafer (610) corresponding to each of the plurality of first semiconductor light emitting or detecting devices (610₁), and at least a second plurality of side-wall reflectors on at least the second processed semiconductor wafer (620) corresponding to each of the plurality of second semiconductor light emitting or detecting devices (620₁).

8. The method according to any of claims 1 to 7,
wherein the method further comprises the steps of:
a) dicing a first epitaxial wafer (201) configured to emit or detect light of the first color and transferring onto the first semiconductor wafer (203) in order to process the plurality of first light emitting or detecting devices (610₁) on the first processed semiconductor wafer (610), and
b) repeating step a) for at least a second epitaxial wafer (201) configured to emit or detect light of the second color in order to process at least the plurality of second light emitting or detecting devices (620₁) on at least the second processed semiconductor wafer (620).

9. The method according to any of claims 1 to 8,
wherein the method further comprises the step of bonding the first processed semiconductor wafer (610), at least the second processed semiconductor wafer (620), and the third semiconductor wafer (300) in the stacked manner so as to form individual pixel elements of the polychrome display or imaging device comprising at least one first semiconductor light emitting or detecting device (610₁) and at least one second semiconductor light emitting or detecting device (620₁), and
wherein the at least one first semiconductor light emitting or detecting device (610₁) and the at least one second light emitting or detecting device (620₁) are arranged as a set of neighboring pixels in order to form the individual pixel elements of the polychrome display or imaging device.

10. The method according to claim 9,
wherein the method further comprises the step of forming the individual pixel elements of the polychrome display or imaging device having a pixel pitch preferably less than 5 micrometers.

11. A polychrome display or imaging device (650, 750) comprising:
a first processed semiconductor wafer (610) comprising a plurality of first semiconductor light emitting or detecting devices (610₁), each configured to emit or detect light of a first color,
at least a second processed semiconductor wafer (620) comprising at least a plurality of second semiconductor light emitting or detecting devices (620₁), each configured to emit or detect light of a second color, and
a third semiconductor wafer (300) comprising an integrated circuit (304) with driving devices for driving the plurality of first semiconductor light emitting or detecting devices (610₁) and the plurality of second semiconductor light emitting or detecting devices (620₁), wherein the first processed semiconductor wafer (610), at least the second processed semiconductor wafer (620), and the third semiconductor wafer (300) are bonded together in a stacked manner, and
wherein the bonding between the first processed semiconductor wafer (610), at least the second processed semiconductor wafer (620), and the third semiconductor wafer (300) comprises at least one dielectric bonding and at least one hybrid bonding.

12. The polychrome display or imaging device according to claim 11,
wherein the first processed semiconductor wafer (610) comprises a first plurality of optical structures (718) corresponding to each of the plurality of first semiconductor light emitting or detecting devices (610₁), and at least the second processed semiconductor wafer (620) comprises at least a second plurality of optical structures (728) corresponding to each of the plurality of second semiconductor light emitting or detecting devices (620₁), or
wherein the polychrome display or imaging device comprises a first plurality of optical structures (618) corresponding to each of the plurality of first semiconductor light emitting or detecting devices (610₁) and at least a second plurality of optical structures (628) corresponding to each of the plurality of second semiconductor light emitting or detecting devices (620₁),and
wherein the first plurality of optical structures (618, 718) and the second plurality of optical structures (628, 728) comprise a digital lens, a digital lens system, a resonant cavity structure, a photo-scattering layer, or a combination thereof.

13. The polychrome display or imaging device according to claim 11 or 12,
wherein the first processed semiconductor wafer (610) comprises a first plurality of side-wall reflectors corresponding to each of the plurality of first semiconductor light emitting or detecting devices (610₁), and at least the second processed semiconductor wafer (620) comprises at least a second plurality of side-wall reflectors corresponding to each of the plurality of second semiconductor light emitting or detecting devices (620₁), and
wherein the first plurality of side-wall reflectors and the second plurality of side-wall reflectors comprise a distributed Bragg reflector, a metallic mirror, an absorber layer, or a combination thereof.

14. The polychrome display or imaging device according to any of claims 11 to 13,
wherein the first processed semiconductor wafer (610) is realized from a first semiconductor wafer (203) comprising a substrate wafer, especially a silicon wafer or a sapphire wafer or a germanium wafer or a GaAs wafer, having at least one compound semiconductor layer or is a compound semiconductor wafer, and
wherein the second processed semiconductor wafer (620) is realized from a second semiconductor wafer (203) comprising a substrate wafer, especially a silicon wafer or a sapphire wafer or a germanium wafer or a GaAs wafer, having at least one compound semiconductor layer or is a compound semiconductor wafer.

15. The polychrome display or imaging device according to any of claims 11 to 14,
wherein the plurality of first semiconductor light emitting or detecting devices (610₁) and at least the plurality of second semiconductor light emitting or detecting devices (620₁) are compound semiconductor light emitting or detecting devices, preferably III-V compound semiconductor light emitting or detecting devices, or
wherein the plurality of first semiconductor light emitting or detecting devices (610₁) are of a first group of compound, especially Gallium Nitride, GaN, semiconductor light emitting or detecting devices and at least the plurality of second semiconductor light emitting or detecting devices (620₁) are of a second group of compound, especially Indium Gallium Arsenide, InGaAs, Aluminum Indium Gallium Phosphide, AlInGaP, semiconductor light emitting or detecting devices.
